Europäisches Patentamt

European Patent Office

Office européen des brevets

(11) Publication number: **0 269 219**
**A2**

## (12) EUROPEAN PATENT APPLICATION

(21) Application number: 87308507.0

(51) Int. Cl.⁴: **G03F 7/02**

(22) Date of filing: 25.09.87

(30) Priority: 03.10.86 US 915076

(43) Date of publication of application:
01.06.88 Bulletin 88/22

(84) Designated Contracting States:
AT BE CH DE ES FR GB GR IT LI LU NL SE

(71) Applicant: ADVANCED MICRO DEVICES, INC.
901 Thompson Place P.O. Box 3453
Sunnyvale, CA 94088(US)

(72) Inventor: Ong, Edith
19902 Via Escuels Drive
Saratoga California 95070(US)
Inventor: Singh, Bhanwar
5857 Southwind Drive
San Jose California 95138(US)

(74) Representative: Wright, Hugh Ronald et al
Brookes & Martin High Holborn House 52/54
High Holborn
London WC1V 6SE(GB)

(54) **Improved photolithography process using two photoresist layers for device fabrication.**

(57) An improved two layer photolithographic process is disclosed for use in the construction of an integrated circuit structure. The improvements comprise applying over a first photoresist layer sensitive to light below about 250 nm a second photoresist layer containing a selective solvent which is not a solvent for the first photoresist layer to inhibit reaction between the layers to form an interfacial layer therebetween; baking the second photoresist layer at a temperature below the glass transition temperature of the resin in the second photoresist layer to further suppress formation of the interfacial layer; and photostabilizing the remaining portions of the second layer after development at a wavelength range which will crosslink the remaining photoresist in the second layer to permit subsequent development of the lower photoresist layer, after exposure, with a high resolution developer which will not dissolve the crosslinked upper photoresist. The crosslinked portions of the second photoresist layer protect the corresponding patterned portions of the first layer thereunder during subsequent dry etching to prevent erosion of the patterned first photoresist.

# IMPROVED PHOTOLITHOGRAPHY PROCESS USING TWO PHOTORESIST LAYERS FOR DEVICE FABRICATION

This invention relates to the production of integrated circuit structures using two layered photolithography. More particularly, this invention relates to improvements in two layered positive photoresist photolithography wherein formation of an interface layer between the two layers of photoresist is inhibited and the patterned portions of both photoresist layers are used to form an improved etch mask.

In the patterning of an integrated circuit structure containing steps, the use of a thick photoresist layer to form a planar surface creates problems due to non-uniformity of the thickness of the photoresist since the use of sufficient exposure time during the photoexposure through a mask in projection lithography, to permit the UV light to pass through the thick portions of the photoresist results in overexposure of the thin portions of the photoresist.

In Lapadula et al U.S. Patent 4,211,834 and in an article by B.J. Lin entitled "Portable Conformable Mask - A Hybrid Near-Ultraviolet and Deep-Ultraviolet Patterning Technique" published in SPIE, Volume 174, Developments in Semiconductor Microlithography IV (1979) at pages 114-121, there is described a portable conformable mask (PCM) concept used to address the above problem. In this approach, a thin upper positive resist layer is separated from the substrate by an intermediate resist layer which is chemically dissimilar so that at least the lower layer is not soluble in the developer for the upper layer. Near-UV radiation is used to expose the top layer while deep-UV is used to expose the bottom layer of photoresist using the patterned upper resist as a mask for the lower resist layer.

In both the patent and the article, the use of a lower layer of a radiation degradable alkyl methacrylate positive photoresist, such as polymethyl methacrylate (PMMA) sensitive to radiation below about 300 nm, is described in combination with an upper layer of an O-quinone diazide sensitized phenol-formaldehyde positive photoresist which is opaque to radiation of wavelength below about 300 nm. After the upper layer has been exposed to a light pattern and developed to remove the exposed portions, the remaining portions of the upper layer are used as a conforming mask to permit patterning of the lower photoresist layer using radiation of wavelength below 300 nm. The exposed portions of the lower mask are then removed using either a developer such as methyl iso-butyl ketone (MIBK), which will also remove the remaining portions of the upper photoresist, or a developer such as chlorobenzene which is selective to remove only the exposed portions of the lower photoresist layer leaving a cap of the upper photoresist over the unexposed portions of the lower photoresist layer.

While this portable conforming mask or two layered photoresist approach did address the problems encountered in using a single thick photoresist layer over a stepped integrated circuit structure, other problems were introduced. If the remaining portions of the upper photoresist layer were removed during development of the exposed lower layer using a developer such as MIBK, which is a solvent for both the upper layer as well as the exposed portions of the lower layer, the resulting mask of PMMA was found to be unsatisfactory for the high resolution dry etching techniques such as $Cl_2$ reactive ion etching since the PMMA was eroded by such dry etching processes.

As an alternate which solves this problem, the same prior art alternatively suggests the use of a developer such as chlorobenzene or toluene which are selective solvents for the exposed portion of the PMMA but not the remaining portions of the upper photoresist which results in protective "caps" of the upper photoresist left over the patterned lower photoresist after its development. These "caps" protect the patterned portions of lower photoresist during subsequent dry etching. However, use of a developer such as chlorobenzene presents environmental problems. Furthermore, a solvent such as MIBK is a higher contrast developer for PMMA than chlorobenzene resulting in a more vertical wall profile in the lower photoresist.

An additional problem which has resulted from the use of such a two layered photoresist process is the formation of an interfacial or "ghost" layer between the two photoresist layers which apparently results from partial dissolving of the surface of the lower photoresist layer in the solvent present in the upper layer as it is applied. Formation of this interfacial layer results in an incomplete developing of the upper layer leaving an interfacial layer which may be as much as 2000N thick. This interfacial layer will then absorb some of the shorter wavelength UV light used to expose the lower photoresist layer which can result in incomplete exposure of the lower photoresist.

The presence of this interfacial layer can also interfere with development of the lower photoresist layer resulting in a skin or an overhang of the lower photoresist remaining after development. Also, when retaining the upper photoresist "caps" using selective developers such as chlorobenzene, it is necessary to provide an additional plasma step, sometimes called a "descumming" step to remove the interfacial layer over the developed portions of the lower level prior to etching. This procedure is not easily controlled and line width resolution can be adversely affected by this procedure.

Feng et al U.S. Patents 4,180,604 and 4,238,559 addressed this problem by describing the saturating of the upper resist material with a dilutant such as xylene, toluene, chlorobenzene, or a Freon-type fluorinated hydrocarbon which will not dissolve the lower resist material.

It was also suggested by one of us in a paper entitled "BILEVEL RESIST PROCESSING TECHNIQUES FOR FINE-LINE LITHOGRAPHY" by E. Ong et al published in the Proceedings of the Kodak Microelectronics Seminar at pp 91-97, October, 1981, that the upper photoresist layer, after application over the lower photoresist layer, should be heated to a temperature below the glass transition temperature of the resin in the photoresist material in both layers to thereby drive off the solvent without flowing the upper layer to avoid interaction between the layers, since heating the upper layer to a temperature sufficient to flow the upper layer to planarize is not necessary since the formation of the lower level of photoresist already results in a planar surface.

Maintaining the heating of the upper photoresist layer below the glass transition temperature of the two photoresist layers is also discussed in an article entitled "MATERIALS FOR MULTILEVEL RESIST SCHEMES" by E. Reichmanis et al, published in Polymer Engineering and Science, December, 1983, Vol. 23, No. 18 at pp 1039-1042 and in "MULTILAYER RESISTS FOR FINE LINE OPTICAL LITHOGRAPHY" BY E. Ong et al published in Solid State Technology in June, 1984 at pp 155-160. In these two articles the use of a solvent for the upper layer which is not a solvent for the lower resist is also discussed.

Another problem which has also resulted in loss of resolution in photolithography is the reflectance back through the photoresist of light used to initially pattern the photoresist when the photoresist is used over a highly reflective layer such as a metal layer.

Chen et al U.S. Patent 4,362,809 and O'Toole et al U.S. Patent 4,370,405 suggested improvements in the portable conformable mask disclosed by Lin to mitigate the reflectance problem by placing a light absorbing dye in the lower photoresist layer to thereby reduce reflectance during the initial exposure of the upper photoresist layer.

The problem of undesired reflectance of light back through the photoresist layer was also addressed in Knight et al U.S. Patent Application Serial No. 650,957, assigned to the assignee of this invention and cross-reference to which is hereby made, wherein a selected amount of a light absorbing agent was incorporated into a single layer of photoresist.

We will now describe an improved two layer photolithographic process wherein formation of an interlayer between the photoresist layers is inhibited.

We will also describe an improved two layer photolithographic process wherein development of the lower layer may be effected without removing the remaining patterned portions of the upper layer using a developer capable of providing high resolution.

We will describe an improved two layer photolithographic process wherein formation of an interlayer between the photoresist layers is inhibited and development of the lower layer may be effected without removing the remaining patterned portions of the upper layer using a developer capable of providing high resolution.

We will describe an improved two layer photolithographic process wherein formation of an interlayer between the photoresist layers is inhibited and development of the lower layer may be effected without removing the remaining patterned portions of the upper layer using a developer capable of providing high resolution and means capable of absorbing radiation at the wavelength used to expose the upper photoresist layer, such as a dye, are incorporated into the lower layer to inhibit reflectance back through the upper layer of the radiation used to pattern the upper photoresist layer.

These and other objects of the invention will be apparent from the following description and accompanying flowsheet.

The present invention provides an improved two layer photolithographic process for use in the construction of an integrated circuit structure wherein the improvements comprise:

(a) applying over said structure a first photoresist layer sensitive to light below about 250 nm;

(b) applying over said first photoresist layer a second photoresist layer sensitive to light above 300 nm which contains a selective solvent which is not a solvent for the first photoresist layer to inhibit reaction between the layers to form an interfacial layer therebetween; and

(c) baking said second photoresist layer to remove solvent at a temperature of from about 55 to 70°C to further inhibit formation of the interfacial layer;

whereby formation of a deleterious interfacial layer between the two photoresist layers is inhibited.

In accordance with another aspect of the invention, an improved two layer photolithographic process is provided for use in the construction of an integrated circuit structure wherein the improvements comprise: applying over a first photoresist layer sensitive to light below about 250 nm, a second photoresist layer whi-h contains a selective solvent which is not a solvent for the first photoresist lager to inhibit reaction between the lagers to form an interfacial lager therebetween; baking the second photoresist layer at a temperature below the glass transition temperature of the resin used in the second photoresist layer to further inhibit formation of the interfacial layer; and stabilizing the remaining portions of the second layer after development by exposing the second layer to radiation of a wavelength range to which the lower photoresist layer is insensitive but which will crosslink the remaining photoresist in the second layer to permit subsequent development of the lower photoresist layer, after exposure, with a high resolution developer which will not dissolve the crosslinked upper photoresist over the remaining undeveloped lower photoresist portions.

In accordance with one embodiment, means capable of absorbing radiation at the wavelength used to expose the upper photoresist layer, such as a dye, are incorporated into the lower layer to inhibit reflectance back through the upper layer of the radiation used to pattern the upper photoresist layer.

## BRIEF DESCRIPTION OF THE DRAWINGS

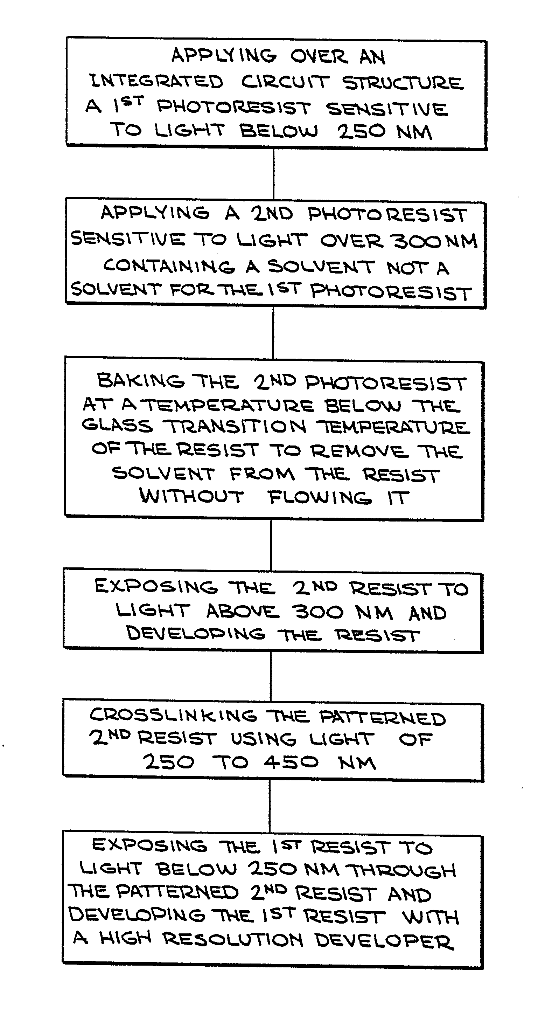

The sole figure is a flowsheet illustrating the process of the invention.

## DESCRIPTION OF THE PREFERRED EMBODIMENTS

The invention comprises an improved two layer photolithography process which results in the inhibition of formation of an interfacial or "ghost" layer between the two layers of photoresist and permits the retention over the lower layer of photoresist of portions of the upper photoresist layer while using a high resolution developer to develop the lower layer. Substantial elimination of formation of an interfacial layer avoids the problems of interference with exposure and/or development of the lower photoresist layer while retention of portions or "caps" of the upper photoresist layer over the remaining portion of the lower photoresist layer after development with a high resolution developer permits use of dry etching techniques without erosion of the lower photoresist mask.

The two layer photoresist mask is formed by first applying to an integrated circuit structure a layer of a positive photoresist comprising a radiation degradable alkyl methacrylate polymer such as polymethyl methacrylate (PMMA), and copolymers of methyl methacrylate and polymethyl methacrylate which is photosensitive at wavelengths below about 250 nm but relatively opaque to wavelengths above about 300 nm. The photoresist material is applied to the stepped integrated circuit structure in a sufficient thickness to provide a layer having a level surface, i.e., about 1 to 3 microns.

The structure is then heated to a temperature of from about 140 to 180°C for from about 30 to 60 minutes in a convection oven (when a batch process is used with a number of wafers) or to a temperature of about 150°C for about 30 to 100 seconds in a single wafer hot plate oven to smooth the photoresist layer and drive off the solvent following which the upper layer of photoresist is applied. The upper layer of photoresist, which is usually applied in a thickness of about 0.2 to 1.2 microns, comprises a phenol-formaldehyde novalak resin containing a photosensitizer such as, for example, naphthoquinone-(1,2)-diazide sulfonic acid ester which renders the material photoactive at wavelengths above 300 nm.

In accordance with one aspect of the invention, the upper layer of photoresist contains a selective solvent which, while acting as a solvent for the photoresist materials in the upper layer, is not a solvent for the lower PMMA layer and hence is denoted as a selective solvent. Examples of such selective solvents include n-butyl acetate, n-butanol, xylene, and methyl isobutyl ketone.

The selective solvent in the upper photoresist material may be present by originally formulating the photoresist using such a solvent; or a mixture of such solvents; or the selective solvent, or solvent mixture, may be added as a dilutant to a commercial photoresist originally formulated with a nonselective solvent such as cellosolve acetate. In the latter case, the photoresist material, which is usually formulated to a typical viscosity of about 15-30 centistokes (cs), is diluted down to a viscosity of about 6-10 cs, preferably about 8 cs, using the selective solvent.

After applying the upper photoresist layer to the integrated circuit structure, the structure is heated to a temperature below the glass transition temperature of the resin in the upper photoresist material, i.e., to a temperature of about 70°C or below, and preferably about 60'C, ±5°C for a time period sufficient to drive off the solvents, which may vary from about 30-100 seconds when a direct contact hot plate is used and from about 30 to 60 minutes when a convection oven is used. By heating the upper layer in this manner, the solvents may be removed without causing the upper layer to flow, thus further inhibiting interaction between the upper and lower photoresist layer to cause formation of the undesirable interfacial layer.

After forming the dual layer photoresist, the upper layer is patterned using a conventional photolithography mask and UV light of wavelength above 300 nm, which may comprise the conventional use of 436 nm light. Although lower wavelengths of light yeld better resolution, the use of the dual layer system permits formation of a thin upper layer which gives better resolution results than a thicker photoresist layer exposed to the same wavelength.

The exposed upper layer is then conventionally developed in a commercial developer containing NaOH, KOH, or tetramethyl ammonium hydroxide which is not a solvent for the lower PMMA photoresist. The remaining patterned upper layer is then photostabilized in accordance with the invention by exposure to UV light for a period of from about 1 to 5 minutes using a wavelength range of from about 250 to 450 nm and a temperature of at least 50°C up to about 70°C to crosslink the resin. This crosslinking of the resin used in the upper photoresist renders the material insoluble in high resolution developers which will subsequently be used in developing the lower photoresist layer as will be described below.

The choice of the 250 to 450 nm range of UV light to crosslink the patterned upper photoresist layer is based on the need to have a wavelength short enough to efficiently crosslink the resin yet not so short as to quickly form an outer skin of crosslinked material through which the UV radiation would not easily penetrate to crosslink the interior of the patterned portions of the upper photoresist layer. It should also be noted that the use of collimated light is not necessary and a diffuse light source may be used instead.

After the crosslinking of the pattern of upper layer photoresist, the lower layer is exposed to UV radiation below 250 nm and then developed. The PMMA lower photoresist layer may be developed using methyl isobutyl ketone (MIBK) or other high resolution developers without risking removal of the patterned mask of upper layer photoresist since the now crosslinked resin of the patterned mask will not be soluble in developers such as MIBK.

The result, then, is a two layer etch mask with "caps" of crosslinked upper photoresist material over the PMMA pattern. This, in turn, means that subsequent use of the two layered mask in dry etching processes, such as reactive ion etching (RIE) using $Cl_2$ plasma, will not result in attack and degradation by erosion of the PMMA mask material.

In another embodiment of the invention, the resolution of the resulting mask may be further enhanced by the incorporation into the lower PMMA layer of photoresist of a radiation-absorbing agent, such as, for example, a dye, capable of absorbing radiation of the wavelength normally used in exposing the upper layer, i.e., above about 300 nm without interfering with the subsequent exposure of the lower layer to light at wavelengths below 250 nm.

The presence of such an absorbing agent in the PMMA layer of photoresist prevents or inhibits the reflection back from a reflective surface beneath the photoresist layers of the light used to expose and photopattern the upper layer. This, in turn, reduces the thickness or line width loss in nominally unexposed regions of the upper layer due to laterally scattered light known as resist notching.

The concentration of the absorbing agent, when added as a dye to the lower photoresist layer, may vary from 1.0 to 4.0% by weight of the total photosensitive material. Preferably the dye is used in a concentration of at least about 2.0 to 3.0 weight per cent.

In a preferred embodiment, the absorbing agent is preselected to have a high absorption at the wavelength used to pattern the upper photosensitive layer, e.g., 436 nm, while exhibiting high transmission of light at wavelengths below 250 nm used to expose the lower photoresist layer.

Dyes which has been found to be useful in the practice of this embodiment of the invention are dyes distributed under the trademarks COUMARIN 504, COUMARIN 535, and COUMARIN 540 by Exciton Corporation of Dayton, Ohio, or COUMARIN 6, COUMARIN 7, and COUMARIN 314 by Eastman Kodak Company. The chemical name of COUMARIN 504 or COUMARIN 314 is 1,2,4,5,3H,6H,1OH-tetrahydro-9-carbethoxy(1)-benzopyrano(9,9a,1-gh) quinolizin-10-one. Other dyes which may also be useful in the invention include photosensitive compounds such as described in Specht et al U.S. Patent 4,289,844.

It should be noted that the absorbing agent need not necessarily be in the form of an added dye, but may rather, for example, comprise a modification of the photosensitive material itself used in the lower layer to increase its absorbance at the wavelength range normally used to expose the upper photoresist layer.

To further illustrate the practice of the invention, a 1.6 micron thick layer of a 9 wt.% PMMA containing 3 wt.%, by weight of PMMA, Coumarin 6 dye was spun at 2000 rpm over a stepped integrated circuit structure. The structure was then baked at 150°C on a hot plate for 1 minute to drive off the chlorobenzene solvent. A second photoresist layer, consisting of KTI 1350JSF-NBA, a phenol-

formaldehyde novalak resin-based positive photoresist dissolved in an n-butyl acetate solvent, was then spun over the first photoresist to a thickness of about 0.9 microns. The structure was then baked at a temperature of 60°C for 1 minute on a hot plate to remove the n-butyl acetate solvent from the upper layer.

The structure was then exposed to 436 nm light through a mask to pattern the upper photoresist layer. The upper layer was then developed using a 1:5 AZ 351/water developing solution, a conventional alkaline developer, using a conventional spray process. The patterned upper photoresist layer was then photostabilized by exposure to diffused light at 250-450 nm for 3 minutes while heating the structure at 60°C to cross-link the remaining portions of the upper layer.

The lower photoresist was then exposed to collimated light at 220 nm through the upper photoresist layer mask for about 2 minutes and then developed using a methyl isobutyl ketone for 45 seconds followed by a rinse in 1:1 isopropanol and deionized water for 30 seconds.

Examination of the resulting two layer resist mask under an SEM showed that both layers were intact, i.e., that the MIBK developer had not attacked the photostabilized top resist mask, that the PMMA wall profile was vertical, and that there was no interfacial problems.

Thus, the process of the invention provides an improved process wherein the formation of an interfacial layer between an upper photoresist layer and a lower photoresist layer is inhibited, the patterned upper photoresist is modified to render it capable of withstanding solvent action of high resolution developers used to develop the lower layer whereby the patterned portions of upper photoresist protect the lower pattern of photoresist during subsequent dry etching, and antireflectance protection for the upper layer is optionally incorporated into the lower photoresist layer.

## Claims

1. An improved two layer photolithographic process for use in the construction of an integrated circuit structure wherein the improvements comprise:

(a) applying over said structure a first photoresist layer sensitive to light below about 250 nm;

(b) applying over said first photoresist layer a second photoresist layer sensitive to light above 300 nm which contains a selective solvent which is not a solvent for the first photoresist layer to inhibit reaction between the layers to form an interfacial layer therebetween; and

(c) baking said second photoresist layer to remove solvent at a temperature of from about 55 to 70°C to further inhibit formation of the interfacial layer;

whereby formation of a deleterious interfacial layer between the two photoresist layers is inhibited.

2. The process of claim 1 including the further steps of patterning said second layer and photostabilizing said patterned second layer to protect subsequently patterned portions of said underlying first layer during subsequent etching of the structure under said patterned photoresist layers.

3. The process of claim 2 wherein said step of photostabilizing said patterned portions of said second photoresist layer comprise exposing said portions to UV light at a wavelength range of from about 250 to 450 nm to crosslink the resin in said patterned photoresist.

4. The process of claim 3 wherein said step of photostabilizing said patterned portions of said second photoresist layer is carried out at a temperature of from at least about 50°C up to about 70°C for a period of from 1 to 5 minutes.

5. The process of claim 4 wherein said step of forming said first layer of photoresist material comprises applying a layer of a photosensitive alkyl acrylate material to said structure.

6. The process of claim 5 wherein said alkyl acrylate material comprises polymethyl methacrylate.

7. The process of claim 6 wherein said selective solvent is selected from the class consisting of n-butyl acetate, n-butanol, and methyl isobutyl ketone.

8. The process of claim 7 wherein said selective solvent is n-butyl acetate.

9. The process of claim 7 wherein said second photoresist layer comprises a photoresist material initially formulated using a selective solvent which will not dissolve the photoresist material used in said first layer.

10. The process of claim 7 wherein said second photoresist layer comprises a photoresist material diluted down to a viscosity of about 6-10 cs using a selective solvent which will not dissolve the photoresist material used in said first layer.

11. The process of claim 7 wherein said step of applying said first photoresist layer over said integrated circuit structure further comprises applying a PMMA photoresist containing a material capable of absorbing light over 300 nm to provide antireflectance protection during the patterning of said second photoresist layer.

12. The process of claim 11 wherein said light absorbing material in said PMMA photoresist material comprises from 1.0 to 4.0 wt.%, based on total weight of the photoresist, of a dye.

13. An improved two layer photolithographic process for use in the construction of an integrated circuit structure wherein the improvements comprise:

(a) applying over a first photoresist layer comprising an alkyl acrylate resin sensitive to light below about 250 nm, a second photoresist layer sensitive to light over 300 nm which has been diluted with a selective solvent which is not a solvent for the first photoresist layer to inhibit reaction between the layers to form an interfacial layer therebetween;

(b) baking the second photoresist layer at a temperature up to about 70°C to remove the solvent from said second layer while inhibiting flow of both of said photoresist layers to further suppress formation of the interfacial layer; and

(c) photostabilizing the remaining portions of the second layer after development by exposing the second layer to radiation of a wavelength range of from about 250 to 450 nm at which the lower photoresist layer is insensitive but which will crosslink the remaining photoresist in the second layer to permit subsequent development of the lower photoresist layer, after exposure, with a high resolution developer which will not dissolve the crosslinked upper photoresist over the remaining undeveloped lower photoresist portions;

whereby formation of an interfacial layer between said photoresist layers will be suppressed and the formation of crosslinked portions of said second photoresist over the subsequently patterned first photoresist layer will protect said patterned first photoresist from erosion during subsequent dry etching of the underlying integrated circuit structure to provide higher resolution photolithography.

14. The process of claim 13 wherein said step of photostabilizing said patterned portions of said second photoresist layer is carried out at a temperature of from at least about 50°C up to about 70°C for a period of from 1 to 5 minutes.

15. The process of claim 14 wherein said selective solvent comprises n-butyl acetate.

16. The process of claim 14 wherein said baking step to remove said solvent from said second photoresist layer is carried out at a temperature of from about 55 up to about 70°C.

17. The process of claim 13 wherein said first layer of PMMA photoresist further contains a material capable of absorbing light over 300 nm to provide antireflectance protection during the patterning of said second photoresist layer.

18. The process of claim 17 wherein said absorbing agent comprises from about 1.0 to 4.0 wt.%, based on total weight of said first photoresist material, of a coumarin based dye.

19. An improved two layer photolithographic process for use in the construction of an integrated circuit structure wherein the improvements comprise:

(a) applying to said structure from about 1 to 3 microns of a first photoresist layer comprising a photosensitive polymethyl methacrylate material sensitive to UV light below about 250 nm and containing a light absorbing material capable of absorbing light above about 300 nm;

(b) applying over said first photoresist layer from about 0.2 to 1.2 microns of a second photoresist material sensitive to UV light of at least 300 nm and containing a solvent which is not a solvent for unexposed portions of said first layer;

(c) baking said second photoresist layer at a temperature of from about 55 to about 70°C to remove the solvent from said second layer while inhibiting flow of both of said photoresist layers to further suppress formation of said interfacial layer; and

(c) photostabilizing the remaining portions of the second layer after development by exposing the second layer to radiation of a wavelength range of from about 250 to 450 nm at a temperature of from about 50 to about 70°C for a period of from about 1 to 5 minutes to crosslink the remaining photoresist in said second layer to permit subsequent development of the lower photoresist layer, after exposure, with a high resolution developer which will not dissolve the crosslinked upper photoresist over the remaining undeveloped lower photoresist portions:

whereby formation of said interfacial layer between said photoresist layers will be suppressed and the formation of crosslinked portions of said second photoresist over the subsequently patterned first photoresist layer will protect said patterned first photoresist from erosion during subsequent dry etching of the underlying integrated circuit structure to provide higher resolution photolithography.

20. The process of claim 19 wherein said step of baking said second layer at a temperature of from about 55 to about 70°C to remove the solvent from said second layer while inhibiting flow of both of said photoresist layers is carried out in a convection oven for a period of from 30 to 60 minutes.

21. The process of claim 19 wherein said step of baking said second layer at a temperature of from about 55 to about 70°C to remove the solvent from said second layer while inhibiting flow of both of said photoresist layers is carried out on a direct contact hot plate for a period of from at least about 30 to 100 seconds.

```
┌─────────────────────────────────┐
│        APPLYING OVER AN         │
│  INTEGRATED CIRCUIT STRUCTURE   │
│   A 1ST PHOTORESIST SENSITIVE   │
│     TO LIGHT BELOW 250 NM       │
└─────────────────────────────────┘
                 │
┌─────────────────────────────────┐
│   APPLYING A 2ND PHOTORESIST    │
│  SENSITIVE TO LIGHT OVER 300 NM │
│    CONTAINING A SOLVENT NOT A   │
│  SOLVENT FOR THE 1ST PHOTORESIST│
└─────────────────────────────────┘
                 │
┌─────────────────────────────────┐
│    BAKING THE 2ND PHOTORESIST   │
│   AT A TEMPERATURE BELOW THE    │
│ GLASS TRANSITION TEMPERATURE    │
│  OF THE RESIST TO REMOVE THE    │
│   SOLVENT FROM THE RESIST       │
│       WITHOUT FLOWING IT        │
└─────────────────────────────────┘
                 │
┌─────────────────────────────────┐
│   EXPOSING THE 2ND RESIST TO    │
│    LIGHT ABOVE 300 NM AND       │
│   DEVELOPING THE RESIST         │
└─────────────────────────────────┘
                 │
┌─────────────────────────────────┐
│  CROSSLINKING THE PATTERNED     │
│  2ND RESIST USING LIGHT OF      │
│       250 TO 450 NM             │
└─────────────────────────────────┘
                 │
┌─────────────────────────────────┐
│   EXPOSING THE 1ST RESIST TO    │
│  LIGHT BELOW 250 NM THROUGH     │
│  THE PATTERNED 2ND RESIST AND   │
│ DEVELOPING THE 1ST RESIST WITH  │
│ A HIGH RESOLUTION DEVELOPER     │
└─────────────────────────────────┘
```